## Europäisches Patentamt
## European Patent Office
## Office européen des brevets

(19)

(11) Veröffentlichungsnummer: **0 163 163**
**B1**

(12) **EUROPÄISCHE PATENTSCHRIFT**

(45) Veröffentlichungstag der Patentschrift: 07.11.90

(21) Anmeldenummer: 85105435.3

(22) Anmeldetag: 03.05.85

(51) Int. Cl.⁵: **H 01 L 23/48,** H 01 L 25/04, H 01 L 21/58

(54) Verfahren zur Herstellung von Leistungshalbleitermodulen mit isoliertem Aufbau.

(30) Priorität: 01.06.84 DE 3420364
16.04.85 DE 3513530

(43) Veröffentlichungstag der Anmeldung:
04.12.85 Patentblatt 85/49

(45) Bekanntmachung des Hinweises auf die Patenterteilung:
07.11.90 Patentblatt 90/45

(84) Benannte Vertragsstaaten:
CH DE FR GB IT LI NL

(56) Entgegenhaltungen:
CH-B- 554 600
DD-A- 209 053
DE-A-2 442 159
DE-A-2 514 922
DE-A-3 009 295
GB-A-2 072 075

(73) Patentinhaber: Asea Brown Boveri
Aktiengesellschaft
Kallstadter Strasse 1
D-6800 Mannheim-Käfertal (DE)

(72) Erfinder: Bunk, Klaus
Paulusstrasse 3
D-6520 Worms (DE)
Erfinder: Leukel, Bernd, Dipl.-Ing.
Breslauer Strasse 56
D-6940 Weinheim (DE)
Erfinder: Weidenauer, Werner, Dipl.-Ing.
Blücherstrasse 44
D-6840 Lampertheim (DE)

(74) Vertreter: Rupprecht, Klaus, Dipl.-Ing. et al
c/o Asea Brown Boveri Aktiengesellschaft
Zentralbereich Patente Postfach 100351
D-6800 Mannheim 1 (DE)

Courier Press, Leamington Spa, England.

EP 0 163 163 B1

## Beschreibung

Die Erfindung bezieht sich auf ein Verfahren zur Herstellung von Leistungshalbleitermodulen in mehreren Lötschritten, wobei die Leistungshalbleitermodule einen isolierten Aufbau aufweisen.

Leistungshalbleitermodule mit isoliertem Aufbau sind z.B. aus dem nicht vor dem Anmeldedatum veröffentlichten Gebrauchsmuster 75 13 432 bekannt. Solche Leistungshalbleitermodule werden durch Löten der Teile hergestellt, wobei die Lötung meistens in mehreren Schritten erfolgt. Dabei wird entweder ein einheitliches Lot für alle Schritte verwendet, oder die Schmelzpunkte der verwendeten Lote werden vom Halbleiterchip zur Grundplatte (Metallbodenplatte) hin abnehmend abgestuft. Jedenfalls wird als Lot mit dem niedrigsten Schmelzpunkt das Lotmaterial Pb Sn 63, teils unter Anwendung von Flußmittel verwendet. Dies zeigt eine Untersuchung der am Markt erhältlichen Leistungshalbleitermodule mit isoliertem Aufbau.

Das Lotmaterial Pb Sn 63 hat einen hohen Zinnanteil und neigt deshalb sehr zur Bildung von intermetallischen Verbindungen, insbesondere wenn silbermetallisierte Teile damit gelötet werden. Dadurch können kritische Lötstellen, das sind insbesondere großflächige und thermisch beanspruchte Lötstellen, verspröden. Die Lötstellen haben eine geringe Lastwechselfestigkeit. Flußmittelzusätze verstärken diese negative Eigenschaft.

Bei Hochleistungsmodulen machen sich unterschiedliche Ausdehnungskoeffizienten der zu verlötenden Teile aus unterschiedlichen Werkstoffen stark bemerkbar. Damit die Lötstellen die gegebenen unterschiedlichen Materialdehnungen ausgleichen können, ist eine relativ große Lotschichtdicke, z.B. 100 µm erforderlich. Dicke Lotschichten sind besonders zwischen einer relativ dicken Metallbodenplatte und darauf aufzulötenden Isolierplatten aus Keramik zweckmäßig. Es hat sich gezeigt, daß die Herstellung einer solchen Metallkeramikverbindung mit einer dicken Lotschicht schwierig herzustellen ist, da dicke Lotschichten dazu neigen, aus dem Bereich der vorgesehenen Lötstelle auszulaufen, so daß im Ergebnis nicht die gewünschte Lotschichtdicke erreicht wird, die eine erforderliche Lastwechselfestigkeit gewährleistet. Außerdem können lunkerartige Stellen auftreten, also Flächen innerhalb einer größeren Lötstelle, die nicht oder nur dünn mit Lotmaterial benetzt sind. Dadurch wird sowohl die abführbare Verlustleistung, als auch die Lastwechselfestigkeit herabgesetzt.

Aus der Patentschrift DD-A-209 053 ist ein Verfahren zur Herstellung von Leistungshalbleitermodulen mit isoliertem Aufbau bekannt. Die Herstellung erfolgt in mindestens zwei Teilschritten unter Verwendung unterschiedlicher Löt- und Montagelehren. Zur Art des verwendeten Lotmaterials ist in der genannten Patentschrift nichts ausgesagt.

In der DE-A-30 09 295 ist ein Halbleiterbaustein und seine Herstellung beschrieben. Dabei wird zunächst eine Halbleiteruntergruppe, bestehend aus einem Halbleiterelement und einer Spannungsentlastungsplatte nach einem nicht angegebenen Verfahren zusammengebondet. Ein angegebenes Direktverbindungsverfahren bezieht sich auf die Herstellung einer metallisierten Isolierschicht. Unter Verwendung der Halbleiteruntergruppe und weiterer Teile wird dann der Halbleiterbaustein mit einem hochschmelzenden Lot gelötet. Benetzungsprobleme sind nicht angesprochen.

In der DE-A-25 14 922 sind zur Verbindung von Halbleiterelementen mit Stromleitungsanschlüssen geeignete Weichlote aufgeführt.

Weiterhin ist in der DE-A-24 42 159 das Problem einer möglichen Blasenbildung in einer Lötschicht zwischen einem Halbleiterelement und einem Kühlkörper dargelegt. Zur Lösung des Problems wird vorgeschlagen, in den Kühlkörper parallel laufende Nuten von 0,025 bis 0,075 mm Tiefe und mit einem Abstand von 0,25 bis 1 mm einzupressen.

Schließlich ist in der Patentschrift CH-C-554 600 ein Halbleiterbauelement mit einer versilberten Elektrode beschrieben. Die Silberschicht ist zu einem in der Patentschrift nicht genannten Zweck aufgerauht, wobei eine Rauhtiefe von 2 bis 5 µm vorgeschlagen wird.

Der Erfindung liegt die Aufgabe zugrunde, ein Verfahren zur Herstellung von Leistungshalbleitermodulen anzugeben, das zu Modulen mit verbesserter Lastwechselfestigkeit führt.

Diese Aufgabe wird durch ein Verfahren zur Herstellung von Leistungshalbleitermodulen in mehreren Lötschritten gelöst, wobei die Leistungshalbleitermodule einen isolierten Aufbau aufweisen, und wobei

in einem ersten Schritt eine Metallbodenplatte auf der Oberseite, bevorzugt nur im Bereich von Flächen, die für eine Lötverbindung vorgesehen sind, aufgerauht wird,

in einem zweiten Schritt unter Verwendung eines hochschmelzenden Lots und von Lötformen eine Trägereinheit und mehrere Halbleitersandwichs durch flußmittelfreies Weichlöten unter Wasserstoff oder Formiergas hergestellt werden, wobei

a) die Halbleitersandwichs jeweils durch übereinander gestapelte Anordnung einer unteren Ausgleichsronde, eines Lötplättchens, eines Halbleiterchips, eines weiteren Lötplättchens und einer oberen Ausgleichsronde hergestellt werden und

b) die Trägereinheit hergestellt wird durch der Anzahl der Halbleitersandwichs entsprechende, übereinander gestapelte Anordnungen je eines Lötplättchens, eines auf seinen Hauptflächen metallisierten Isolierplättchens, eines weiteren Lötplättchens und einer beispielsweise aus Kupfer bestehenden Lasche auf ausgewählten Flächen der aufgerauhten Metallbodenplatte und

in einem dritten Schritt die Halbleitersandwichs und die Trägereinheit durch flußmittelfreies Löten unter Wasserstoff oder Formiergas mit einem niedrigschmelzenden Lot miteinander verbunden werden.

Das erfindungsgemäße Verfahren hat den Vorteil, daß mit einer relativ geringfügigen Änderung des Herstellverfahrens für bewährte Module mit stabiler Metallbodenplatte eine gute Lastwechselfestigkeit erzielt wird, die z.B. von Modulen mit durch direkt-bonding hergestellten Metall-Keramik-Substraten bekannt ist. Beim erfindungsgemäßen Verfahren wird nämlich an der Metallbodenplatte ein hochschmelzendes Lot verwendet. Außerdem ergibt sich ein günstiger Fertigungsablauf, da größere Teile eines Moduls, nämlich Halbleitersandwichs und Trägereinheiten in einer parallelen Fertigung vorgefertigt werden. Weiterhin ist vorteilhaft, daß nur zwei aufeinanderfolgende Lötvorgänge erforderlich sind. Denn bei jedem Erwärmungsvorgang werden zuvor hergestellte Lötstellen in ihrem Gefüge verändert, auch wenn nicht der Schmelzpunkt des Lotmaterials erreicht wird.

Das erfindungsgemäße Verfahren hat weiterhin den Vorteil, daß durch die Rauhigkeit des Metallbodens das Lotmaterial nicht aus dem Bereich der Lötstelle herausläuft und außerdem eine gleichmäßige Benetzung erreicht wird. Vorteilhafte Ausgestaltungen sind in Unteransprüchen angegeben.

Eine genauere Beschreibung der Verfahren erfolgt anhand von in der Zeichnung dargestellten Ausführungsbeispielen.

Es zeigen.

Fig. 1a Einzelteile eines Halbleitersandwichs,

Fig. 1b gelötetes Halbleitersandwich,

Fig. 2a Teile einer Trägereinheit,

Fig. 2b gelötete Trägereinheit,

Fig. 3 Kombination einer Trägereinheit mit zwei Halbleitersandwichs

Fig. 4 Metallbodenplatte mit aufgerauhten Flächen.

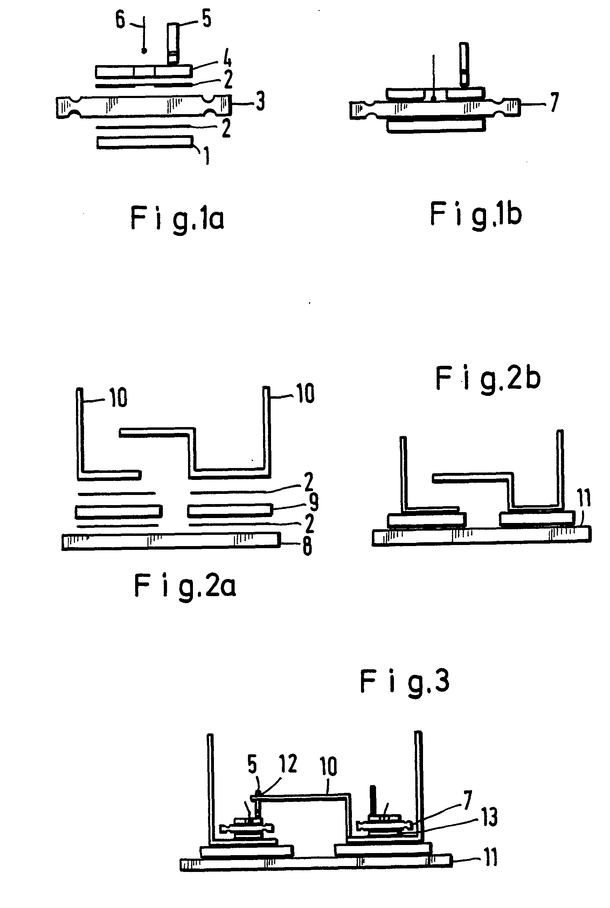

Fig. 1a zeigt die erforderlichen Teile für ein Halbleitersandwich 7 (siehe Fig. 1b). Das Sandwich 7 setzt sich in der Reihenfolge von unten nach oben aus nachstehenden Teilen zusammen: Untere Ausgleichsronde 1 aus z.B. Molybdän oder Vacon, hochschmelzendes Lot 2 in Form eines Plättchens, Siliziumhalbleiterchip 3, hochschmelzendes Lot 2 in Form eines kreisringförmigen Plättchens, obere Ausgleichsronde 4, die durch Hartlöten mit einem Kathodenstempel 5 verbunden ist, und vorbeloteter Draht 6 aus Kupfer für einen Steueranschluß. Die Teile werden in eine Lötform eingesetzt und unter Wasserstoff oder Formiergas gelötet. Als hochschmelzendes Lot 2 kann z.B. Pb Sn 5 oder Pb Ag Sn verwendet werden.

Fig. 1b zeigt das fertig gelötete Halbleitersandwich 7, das aus den in Fig. 1a dargestellten Teilen 1 bis 6 besteht.

Fig. 2a zeigt die Einzelteile einer Trägereinheit 11 (siehe Fig. 2b). Dabei sind über eine Metallbodenplatte 8 aus vernickeltem Kupfer angeordnet: Hochschmelzendes Lot 2 in Form eines Plättchens, Isolierplättchen 9 aus z.B. $Al_2O_3$ oder BeO mit einer Dünnfilm-Metallisierung aus Mo Mg Ni Au oder Wo Ni Au oder einer durch Direkt-Bonding hergestellten Metallisierung, hochschmelzendes Lot 2 in Form eines Plättchens und Laschen 10 aus z.B. versilbertem oder vernickeltem Kupfer. Auch diese Teile werden in eine Lötform gesetzt und unter Wasserstoff oder Formiergas gelötet. Fig. 2b zeigt die fertig gelötete Trägereinheit 11, die aus den in Fig. 2a dargestellten Teilen 2, 8 bis 10 besteht.

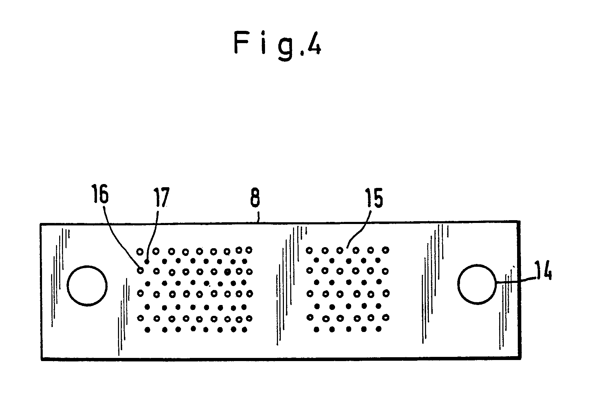

Nach dem ersten Herstellungsschritt, in welchem die Metallbodenplatte aufgerauht wird, wie weiter unten anhand der Fig. 4 beschrieben, und einem zweiten Schritt, bei dem in einer parallelen Fertigung Halbleitersandwichs 7 und Trägereinheiten 11 hergestellt werden, erfolgt in einem dritten Schritt eine Kombination der Teile 7, 11.

Dazu werden, wie in Fig. 3 dargestellt, in eine Trägereinheit 11 z.B. zwei Halbleitersandwichs 7 unter Zwischenlage von niedrigschmelzendem Lot 13 in Form von Plättchen eingesetzt. Als niedrigschmelzendes Lot 13 kann z.B. Sn Ag 3,5 mit einem Schmelzpunkt von etwa 230°C verwendet werden. Die Lötung erfolgt unter Wasserstoff oder Formiergas. Die Plättchen aus niedrigschmelzendem Lot 13 werden so bemessen, daß möglichst keine Berührung mit dem hochschmelzenden Lot 2 während des zweiten Herstellungsschrittes auftritt und somit eine Lotmischung zu Pb Sn 63 vermieden wird. Im übrigen ist die Verwendung von niedrigschmelzendem Lot 13 an dieser Stelle weniger kritisch in bezug auf die Lastwechselfestigkeit des Moduls. Kritische Stellen sind die großflächigen Lötverbindungen zwischen Lasche 10 und Isolierplättchen 9 bzw. zwischen Isolierplättchen 9 und Metallbodenplatte 8 sowie die thermisch beanspruchten Lötstellen zwischen dem Siliziumhalbleiterchip 3 und Ausgleichsronde 1, 4, die alle mit hochschmelzendem Lot 2 gelötet werden. Eine Verbindungsstelle 12 zwischen der dargestellten Lasche 10 und dem Kathodenstempel 5 wird in einem späteren Arbeitsgang hergestellt, bei dem auch nicht dargestellte Verbindungen zu äußeren Anschlüssen hergestellt werden.

Der oben erwähnte erste Verfahrensschritt zur Herstellung einer aufgerauhten Metallbodenplatte 8 wird anhand der Fig. 4 erläutert. Eine so aufgerauhte Bodenplatte 8 erlaubt die Herstellung einer Metall-Keramikverbindung mit einer relativ dicken Lotschicht, von z.B. 100 μm.

Figur 4 zeigt eine Draufsicht auf die Oberseite einer Metallbodenplatte 8 mit Befestigungslöchern 14 und aufgerauhten Flächen 15, die für Lötverbindungen vorgesehen sind. Die Aufrauhung könnte sich auch auf die gesamte Oberseite der Metallbodenplatte 8 erstrecken. Dabei könnten sich jedoch Probleme bei einer eventuell vorgesehenen Verklebung eines Kunststoffgehäuses auf dem Rand der Oberfläche der Metallbodenplatte ergeben. Bevorzugt wird deshalb die Aufrauhung nur im Bereich der für eine Lötverbindung vorgesehenen Flächen 15 vorgenommen.

Geeignet ist eine Rauhigkeit von etwa 6 bis 50 μm, bevorzugt wird eine Rauhigkeit von 6 bis 20 μm. Die Rauhigkeit kann auf verschiedene Weise hergestellt werden. Durch Sandstrahlen kann eine sehr gut geeignete Rauhigkeit von z.B.

10μm erreicht werden. In Versuchen hat sich gezeigt, daß die damit hergestellten etwa punktförmigen Vertiefungen mit etwas unterschiedlicher Tiefe besonders gut geeignet sind. Allerdings erfordert die Herstellung der rauhen Flächen durch Sandstrahlen einen weiteren Arbeitsgang zur Beseitigung von Sandresten von der Oberfläche.

Als weitere Möglichkeit zur Herstellung einer Rauhigkeit von z.B. 20 μm kommt Schleifen in Betracht.

Einer Oberflächenstruktur, die etwa der Aufrauhung durch Sandstrahlen entspricht, kann auch durch Prägen hergestellt werden. Damit kann eine definierte Rauhigkeit bis etwa 50 μm erreicht werden. Es ist sowohl eine Aufrauhung durch Prägen von reltaiv groben Vertiefungen 16 als auch von feinen Vertiefungen 17 möglich, sowie auch eine Kombination aus groben und feinen Vertiefungen 16, 17, die in Figur 4 dargestellt ist. Die Herstellung der groben und feinen Vertiefungen 16, 17 kann zugleich oder nacheinander erfolgen. Im Gegensatz zum Sandstrahlen ist keine Nachbehandlung erforderlich.

**Patentansprüche**

1. Verfahren zur Herstellung von Leistungshalbleitermodulen mit isoliertem Aufbau in mehreren Lötschritten, dadurch gekennzeichnet, daß

in einem ersten Schritt eine Metallbodenplatte (8) auf der Oberseite, bevorzugt nur im Bereich von Flächen (15), die für eine Lötverbindung vorgesehen sind, aufgerauht wird,

in einem zweiten Schritt unter Verwendung eines hochschmelzenden Lots und von Lötformen eine Trägereinheit (11) und mehrere Halbleitersandwichs (7) durch flußmittelfreies Weichlöten unter Wasserstoff oder Formiergas hergestellt werden, wobei

a) die Halbleitersandwichs (7) jeweils durch übereinander gestapelte Anordnung einer unteren Ausgleichsronde (1), eines Lötplättchens (2), eines Halbleiterchips (6), eines weiteren Lötplättchens (2) und einer oberen Ausgleichsronde (4) hergestellt werden und

b) die Trägereinheit (11) hergestellt wird durch der Anzahl der Halbleitersandwichs (7) entsprechende, übereinander gestapelte Anordnungen je eines Lotplättchens (2), eines auf seinen Hauptflächen metallisierten Isolierplättchens (9), eines weiteren Lötplättchens (2) und einer beispielsweise aus Kupfer bestehenden Lasche (10) auf ausgewählten Flächen der aufgerauhten Metallbodenplatte (8) und

in einem dritten Schritt die Halbleitersandwichs (7) und die Trägereinheit (11) durch flußmittelfreies Löten unter Wasserstoff oder Formiergas mit einem niedrigschmelzenden Lot (13) miteinander verbunden werden.

2. Verfahren nach Anspruch 1, dadurch gekennzeichnet, daß als hochschmelzende Lote (2) solche mit einem Schmelzpunkt über 300°C verwendet werden, wie z.B. Pb Sn 5 oder Pb Ag Sn.

3. Verfahren nach Anspruch 1 oder 2, dadurch gekennzeichnet, daß als niedrigschmelzendes Lot (13) Sn Ag 3,5 verwendet wird.

4. Verfahren nach einem der vorstehenden Ansprüche, dadurch gekennzeichnet, daß die Rauhigkeit der aufgerauhten Fläche (15) etwa 6 bis 50 μm, bevorzugt 6 bis 20 μm beträgt.

5. Verfahren nach einem der vorstehenden Ansprüche, dadurch gekennzeichnet, daß die aufgerauhte Fläche (15) durch Sandstrahlen hergestellt wird.

6. Verfahren nach einem der Ansprüche 1 bis 4, dadurch gekennzeichnet, daß die aufgerauhte Fläche (15) durch Schleifen hergestellt wird.

7. Verfahren nach einem der Ansprüche 1 bis 4, dadurch gekennzeichnet, daß die aufgerauhte Fläche (15) durch prägen von Vertiefungen hergestellt wird.

8. Verfahren nach Anspruch 7, dadurch gekennzeichnet, daß sowohl grobe Vertiefungen (16) als auch feine Vertiefungen (17) hergestellt werden.

**Revendications**

1. Procédé de fabrication de modules semi-conducteurs de puissance à structure isolée, en plusieurs étapes de soudage, caractérisé par le fait que

dans une première étape, une plaque d'embase métallique (8) est rendue rugueuse, de préférence uniquement dans la partie des surfaces (15) qui sont prévues pour une liaison par soudage,

dans une deuxième étape, on fabrique, avec utilisation d'une soudure à point de fusion élevé et de formes de soudage, une unité de support (11) et plusieurs sandwichs semi-conducteurs (7) par soudage tendre exempt de décapant, sous atmosphère d'hydrogène ou de gaz inerte protecteur,

a) les sandwichs semi-conducteurs (7) étant fabriqués chaque fois par superposition d'un disque de compensation (1) inférieur, d'une plaquette de soudure (2), d'une pastille semi-conductrice (3), d'une autre plaquette de soudure (2) et d'un disque de compensation (4) supérieur, et

b) l'unité de support (11) étant fabriquée par des superpositions, en nombre correspondant à celui des sandwichs semi-conducteurs (7), chaque fois d'une plaquette de soudure (2), d'une plaquette d'isolation (9) métallisée sur ses surfaces principales, d'une autre plaquette de soudure (2) et d'une cosse (10) par exemple en cuivre, sur des surfaces sélectionnées de la plaque d'embase métallique (8) rendue rugueuse, et

dans une troisième étape, les sandwichs semi-conducteurs (7) et l'unité de support (11) sont reliés entre eux par soudage exempt de décapant, sous atmosphère d'hydrogène ou de gaz inerte protecteur, avec une soudure (13) à bas point de fusion.

2. Procédé selon la revendication 1, caractérisé par le fait qu'on utilise en tant que soudures (2) à point de fusion élevé des soudures dont le point de f'usion est supérieur à 300°C, par exemple Pb Sn 5 ou Pb Ag Sn.

3. Procédé selon revendication 1 ou 2, caractérisé par le fait qu'on utilise Sn Ag 3,5 en tant que soudure (13) à bas point de fusion.

4. Procédé selon l'une des revendications précédentes, caractérisé par le fait que la rugosité de la surface (15) rendue rugueuse est d'environ 5 à 50 µm, de préférence 6 à 20 µm.

5. Procédé selon l'une des revendications précédentes, caractérisé par le fait que la surface rugueuse (15) est réalisée par sablage.

6. Procédé selon l'une des revendications 1 à 4, caractérisé par le fait que la surface rugueuse (15) est réalisée par ponçage.

7. Procédé selon l'une des revendications 1 à 4, caractérisé par le fait que la surface rugueuse (15) est réalisée par des creux obtenus par estampage.

8. Procédé selon la revendication 7, caractérisé par le fait que aussi bien des grands creux (16) que des creux fins (17) sont réalisés.

**Claims**

1. Process for producing power semiconductor modules having an insulated construction in a plurality of soldering steps, characterized in that

in a first step, the top of a metal base plate (8) is roughened, preferably only in the region of areas (15) which are provided for a solder join,

in a second step, a carrier unit (11) and a plurality of semiconductor sandwiches (7) are produced by flux-free soft soldering under hydrogen or forming gas using a high-melting solder and solder preforms,

a) the semiconductor sandwiches (7) being produced in each case by stacked disposition of a lower round compensating blank (1), a solder platelet (2), a semiconductor chip (6) [sic], a further solder platelet (2) and an upper round compensating blank (4) on top of one another, and

b) the carrier unit (11) being produced by the stacked dispositions, corresponding to the number of semiconductor sandwiches (7), of one each of a solder platelet (2), an insulating platelet (9) metallized on its main surfaces, a further solder platelet (2) and a bracket (10) composed, for example, of copper on top of one another on selected areas of the roughened metal base plate (8), and

in a third step, the semiconductor sandwiches (7) and the carrier unit (11) are joined to each other by flux-free soldering under hydrogen or forming gas using a low-melting solder (13).

2. Process according to Claim 1, characterized in that solders having a melting point of over 300°C such as, for example, Pb Sn 5 or Pb Ag Sn are used as high-melting solders (2).

3. Process according to Claim 1 or 2, characterized in that Sn Ag 3.5 is used as low-melting solder (13).

4. Process according to one of the previous Claims, characterized in that the peak-to-valley height of the roughened area (15) is 6 to 50 µm, preferably 6 to 20 µm.

5. Process according to one of preceding Claims, characterized in that the roughened area (15) is produced by sand blasting.

6. Process according to one of Claims 1 to 4, characterized in that the roughened area (15) is produced by grinding.

7. Process according to one of Claims 1 to 4, characterized in that the roughened area (15) is produced by stamping depressions.

8. Process according to Claim 7, characterized in that either coarse depressions (16) or fine depressions (17) are produced.

Fig.1a

Fig.1b

Fig.2b

Fig.2a

Fig.3

# Fig.4